# EUROPEAN PATENT APPLICATION

(11) **EP 0 851 492 A2**
(43) Date of publication of application: **01.07.1998**
(21) Application number: 97121537.1
(22) Date of filing: 08.12.1997
(51) Int. Cl.: H01L 23/538

(54) **Surface-mounted substrate structure and method**

(30) Priority: 06.12.1996 US 31484 P
(71) Applicant: Texas Instruments Incorporated, Dallas, Texas 75265 (US)
(72) Inventor: Gooch, Roland, Dallas, TX 75231 (US)
(74) Representative: Holt, Michael

(57) **Abstract**

A surface-mounted substrate structure is provided that includes a substrate (10), a doped semiconductor layer (16), and a dielectric layer (14). The substrate (10) has an upper surface and a lower surface and an interconnect opening (12) extending between the upper surface and the lower surface of the substrate (10). The doped semiconductor layer (16) is positioned within the interconnect opening (12). The doped semiconductor layer (16) is also positioned above the upper surface and below the lower surface of the substrate material (10) in an area surrounding the interconnect opening (12). The dielectric layer (14) is positioned between the doped semiconductor layer (16) and the substrate material (10).

## Description

### TECHNICAL FIELD OF THE INVENTION

This invention relates generally to the fields of fabrication, packaging, and surface-mounting of integrated circuits and more particularly to a surface-mounted substrate structure and method for forming the same.

### BACKGROUND OF THE INVENTION

Packaging costs are a significant portion of the total costs of integrated circuits ("ICs") and microelectronic mechanical systems ("MEMS"). Packaging costs are even a more significant portion of overall costs in devices in which conventional, low cost, injection molded plastic packaging cannot be used. MEMSs include such devices as bolometers, silicon accelerometers, silicon gyroscopes, and digital light processors. Injection molded plastic packaging is generally not suitable for MEMs. A silicon wafer is the substrate used in a MEMS devices for both mechanical support and integrated electronics functions.

Packaging costs are even a more significant portion of overall costs when IC applications and MEMS applications require windows for receiving optical inputs. For example, such devices as an erasable programmable read-only memory ("EPROM") and a bolometer detector require a window for receiving optical inputs. The placement and attachment of the window is time consuming and expensive. Some MEMS applications also require a hermetically sealed environment and still others require a vacuum environment or both. The packaging costs incurred when fabricating these types of applications greatly contribute to overall costs.

An example of a MEMS application that requires both a window for receiving optical inputs and a hermetic seal and a vacuum seal is a bolometer detector that may be mounted in a standard ceramic or metal package. The bolometer detector is generally attached to the foundation of the package using a solder. The bolometer detector contains bonding pads, much like the die of an IC, which must be electrically coupled to the leads of the package, such as dual-in-line package ("DIP"). This is generally accomplished using wire bonding techniques which use very thin gold or aluminum wire. Next, the optical window or glass must be attached over the bolometer detector and wire bonds such that the bolometer detector and wire bonds are hermetically and vacuum sealed.

This procedure is very time consuming and expensive, including labor, material, and equipment costs, and is complicated by the fact that materials within the hermetically sealed and vacuum sealed environment, such as solder and other packaging materials, may outgas and degrade the vacuum.

After an IC or MEMS has been fabricated and packaged, it is generally mounted on a printed circuit board. Printed circuit board area is often very limited or scarce and problems arise when attempting to lay out or design how the circuit devices, including the ICs and MEMS, will be placed on the printed circuit board. Often, multiple ICs and MEMS must be located on the printed circuit board. If all of the ICs and MEMSs cannot be properly placed on the available printed circuit board area, either the printed circuit board must be enlarged or circuitry eliminated. Either option presents substantial problems.

### SUMMARY OF THE INVENTION

From the foregoing it may be appreciated that a need has arisen for a surface-mounted substrate structure and method for forming the same that eliminates or reduces the problems and disadvantages described above. In accordance with the present invention, a surface-mounted substrate structure and method are provided that reduce packaging costs and overall fabrication costs for both MEMS and IC devices by eliminating the traditional packaging and integrating the encapsulation of the device into the wafer fabrication process. The device may then be mechanically attached to a circuit board using surface mounting technology. The present invention also allows more MEMS and IC devices to be mounted on a printed circuit board.

According to an embodiment of the present invention, a surface-mounted substrate structure is provided that includes a substrate material, a conductive layer, and an oxide layer. The substrate material has an upper surface and a lower surface and an interconnect opening extending between its upper surface and lower surface. The conductive layer is positioned within the interconnect opening and around the upper surface and lower surface of the substrate material where the interconnect opening resides. The oxide layer is positioned between the conductive layer and the substrate material.

A technical advantage of the present invention includes the elimination of bond wire and the accompanying labor and equipment needed to connect the bond wire between the bonding pads and leads of a DIP. Another technical advantage of the present invention includes a decreased parts count as the bottom surface of the substrate structure becomes the bottom surface of the packaged device. Yet another technical advantage of the present invention includes increased IC or MEMS density on a printed circuit board since the devices are mounted directly on the printed circuit board and the additional area consumed by excess packaging material is eliminated.

### BRIEF DESCRIPTION OF THE DRAWINGS

For a more complete understanding of the present invention and the advantages thereof, reference is now made to the following brief description, taken in connection with the accompanying drawings and detailed description, wherein like reference numerals represent like parts or similar areas, in which:
FIGUREs 1A through 1G are a series of schematic cross-sectional diagrams illustrating one embodiment of a surface-mounted substrate structure and method for forming the same;
FIGURE 2 is a schematic cross-sectional diagram illustrating one embodiment of the surface-mounted substrate structure as mounted on a circuit board; and
FIGURE 3 is a schematic cross-sectional diagram illustrating another embodiment of the surface-mounted substrate structure having an insulating protective coating and as mounted on the circuit board.

### DETAILED DESCRIPTION OF THE INVENTION

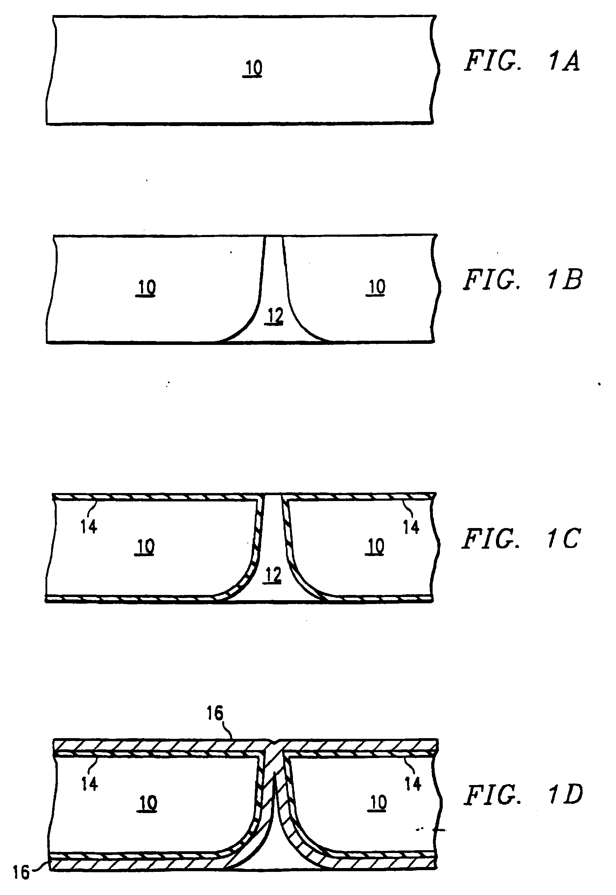

FIGUREs 1A through 1G are a series of schematic cross-sectional diagrams illustrating one embodiment of the fabrication of a surface-mounted substrate structure according to the present invention. Referring to FIGURE 1A, a substrate 10 is provided which may be made of any suitable material. For example, substrate 10 may be provided as a silicon bulk wafer substrate, such as single-crystalline silicon, with a thickness of around twenty to twenty-five mils.

Referring now to FIGURE 1B, an interconnect opening 12 is formed through substrate 10. Interconnect opening 12 may be formed using known or conventional etching techniques such as orientation dependent etch ("ODE") or other suitable methods, such as a laser. Interconnect opening 12 can be formed by starting at a bottom surface of substrate 10 and etching a hole through substrate 10 to an upper surface. In one embodiment, the profile of interconnect opening 12, as illustrated in FIGURE 1B, will present angled walls. The opening of interconnect opening 12 may be greater on the bottom surface than on the upper surface.

Proceeding next to FIGURE 1C, a dielectric layer 14 is grown or deposited on the exposed surfaces of substrate 10. This includes the upper and lower surfaces and the internal surface walls of interconnect opening 12. Dielectric layer 14 may be formed by growing or depositing an oxide using any known or conventional techniques. Dielectric layer 14 may be provided as silicon dioxide if substrate 10 is provided as a silicon substrate.

Referring now to FIGURE 1D, a doped semiconductor layer 16 is deposited on the exposed surface of dielectric layer 14. Doped semiconductor layer 16 may be doped with either p-type dopant, such as boron, to form a p+ layer, or with an n-type dopant, such as phosphorous. In either event, doped semiconductor layer 16 will be provided as either a p-type or an n-type layer and will generally be provided as a doped polysilicon layer that serves as a conductor. Doped semiconductor layer 16 covers the exposed portion of dielectric layer 14 and thus is shown covering the exposed surface of dielectric layer 14 within interconnect opening 12. It should also be noted that interconnect opening 12 will be "pinched" or closed off at the opening near the upper surface of substrate 10. By design, the diameter of interconnect opening 12 and the thickness of doped semiconductor layer 16 are chosen to cause interconnect opening 12 to be sealed. Doped semiconductor layer 16 may be deposited using conventional deposition techniques or any of a variety of deposition techniques such as chemical vapor deposition.

Referring now to FIGURE 1E, portions of doped semiconductor layer 16 are removed through etching. The portions that were removed previously resided on the upper surface of dielectric layer 14 and substrate 10.

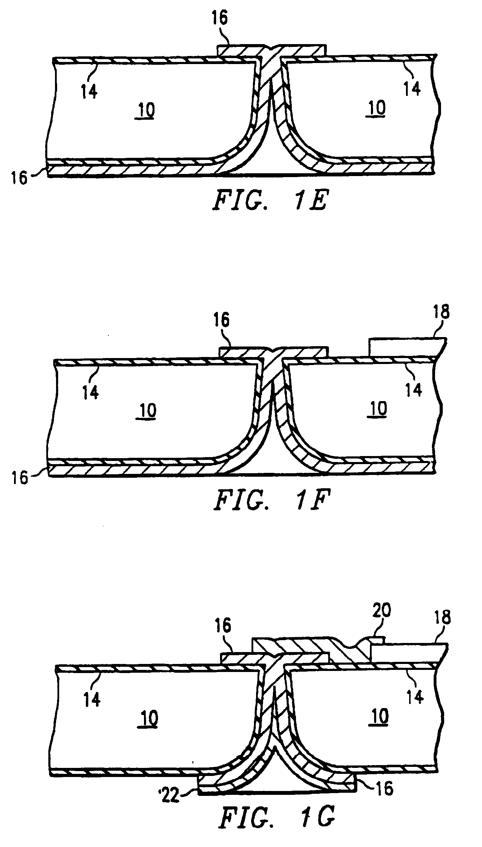

Referring now to FIGURE 1F, a device 18 is fabricated or built within the area or region next to the portion of doped semiconductor layer 16 that remains on the surface of dielectric layer 14 and substrate 10. Device 18 may be virtually any device such as a MEMS or IC. Generally, MEMS are fabricated on the surface of substrate 10 and dielectric layer 14 and use these layers for mechanical support. However, ICs generally include doped regions, for example source regions and drain regions for field-effect transistors, that are fabricated into substrate 10. ICs may include any of a variety of individual circuit elements such as transistors, capacitors, resistors, diodes, and virtually any circuit element that may be fabricated within a substrate such as substrate 10. If device 18 is fabricated as an IC, dielectric layer 14 may be patterned and etched away so that device 18 may extend within substrate 10.

Referring finally to FIGURE 1G, a contact metal 22 is provided within the remaining portion of interconnect opening 12 and extends over the exposed surface of doped semiconductor layer 16 that is present within interconnect opening 12 and the bottom of dielectric layer 14 and substrate 10. After contact metal 22 has been deposited onto doped semiconductor layer 16, portions of both contact metal 22 and doped semiconductor layer 16 that reside on either side of interconnect opening 12 are removed using any suitable or conventional etching method. Contact metal 22 is later used for contacting a circuit board interconnect line or a conductor within an IC package.

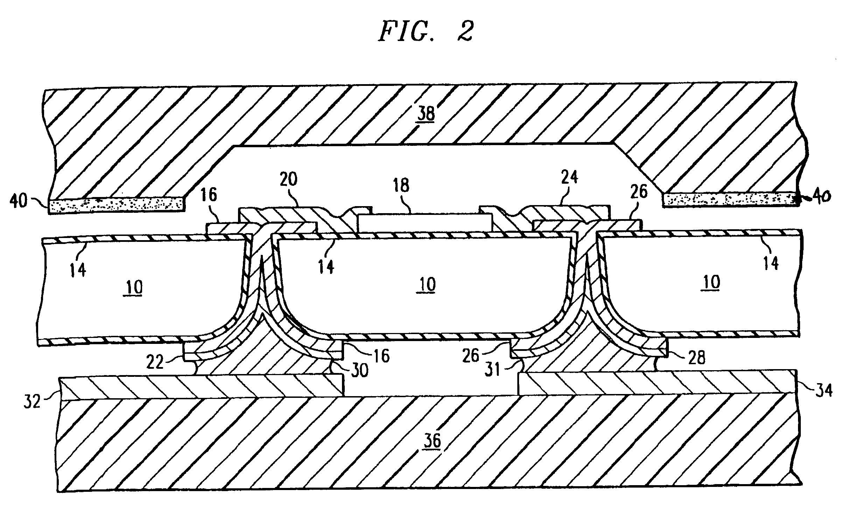

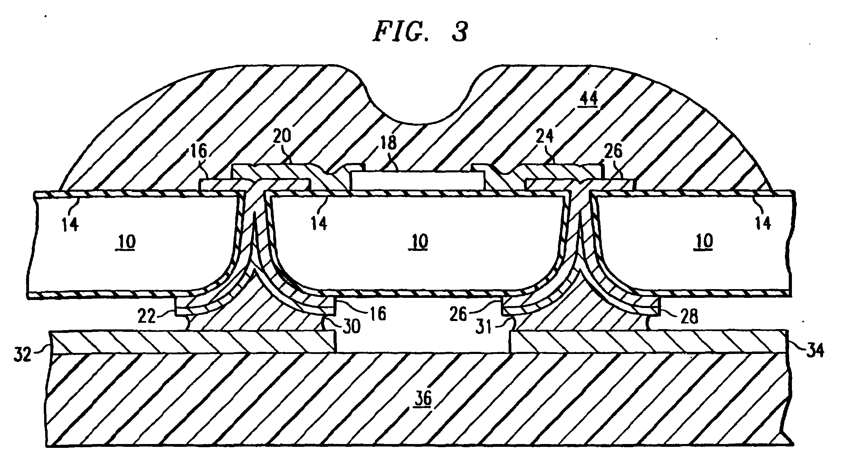

An interconnect metal 20 is deposited between doped semiconductor layer 16, residing on the upper surface of dielectric layer 14, and device 18. Interconnect metal 20 serves as a conductor between a contact or bonding pad location of device 18 and doped semiconductor layer 16. As illustrated, portions of interconnect metal 20 may reside on the upper surface of doped semiconductor layer 16 and device 18. Thus, by providing interconnect metal 20 as shown in FIGURE 1G, a conductor path is provided between a contact or bonding pad location of device 18 and contact metal 22. Interconnect metal 20 may be virtually any available metal or layers of metals capable of being deposited such as aluminum, titanium-tungsten-gold, or other suitable metals. As will be illustrated in FIGUREs 2 and 3, contact metal 22 will serve as one surface-mount connection point for providing an electrical connection to device 18.

Although one embodiment has been illustrated in FIGUREs 1A through 1G, it should be noted that the order in which the various processes occur may be varied and interchanged as desired. For example, the removal of portions of doped semiconductor layer 16, such as those portions previously residing on the bottom surface of dielectric layer 14 and substrate 10, may be removed before or after those portions that are removed from the upper surface of dielectric layer 14 and substrate 10. In the preferred embodiment, the portions of doped semiconductor layer 16 residing on the bottom surface of dielectric layer 14 and substrate 10 will be removed during later processing steps along with the removal of contact metal 22.

FIGURE 2 is a schematic cross-sectional diagram illustrating of one embodiment of the surface-mounted substrate structure with a cover 38 and as mounted on a circuit board 36. As was illustrated in FIGUREs 1A through 1G, the surface-mounted substrate structure may include device 18 electrically coupled from an upper surface of substrate 10 to a lower surface of substrate 10 through various interconnect openings such as interconnect opening 12 of FIGUREs 1A through 1G. FIGURE 2 illustrates two such connections from device 18. Device 18 is one of a number of devices that may be mounted or fabricated on a wafer that includes a surface-mounted substrate structure for each device.

Device 18 couples to contact metal 22 through an interconnect opening in substrate 10 that includes doped semiconductor layer 16 and contact metal 22. Device 18 also couples to contact metal 28 through an interconnect opening in substrate 10 that includes a doped semiconductor layer 26 and a contact metal 28. Once cover 38 has been attached in a later step, device 18 may be electrically probed through the contact metals on the lower or back side of the surface-mounted substrate structure. After the wafer probe, device 18, which could be a MEMS or IC, may be sawed or cut into individual devices. The devices are now ready for surface-mounting on a printed circuit board.

Device 18 may be encapsulated, hermetically sealed, and even vacuum sealed by enclosing with cover 38. Cover 38 may be constructed from any suitable material that provides rigidity and may be fabricated or shaped to a desired geometry. Cover 38 can be attached using a bonding layer 40 which will generally be provided as an epoxy or low melting point solder or glass. Cover 38 may also provide a non-opaque window in the event device 18 requires an optical input.

Next, the surface-mounted substrate structure is mounted on circuit board 36. Circuit board 36 may be virtually any type of circuit board such as a ceramic or fiberglass printed circuit board. The mounting of the surface-mounted substrate structure to a printed circuit board, such as circuit board 36, will generally consume significantly less overall printed circuit board area as compared to mounting a conventional DIP to a printed circuit board. Circuit board 36 may also be an inside surface of a DIP or similar packaging device. Circuit board 36 includes a conductor line 32 and a conductor line 34 for providing a conductive path. Conductor line 32 and conductor line 34 may be a circuit board interconnection line or a conductor within a packaging device such as a DIP.

Contact metal 22 couples to conductor line 32 through a mounting material 30. Mounting material 30 may be a solder, conductive epoxy, or other surface-mounting material that provides an electrically conductive path between conductor line 32 and contact metal 22 as well as mechanical attachment. Similarly, contact metal 28 electrically couples to conductor line 34 using a mounting material 31 that is similar to mounting material 30. Thus, the desired leads or interconnections to device 18 are provided through the surface-mounted substrate structure so that direct surface-mounting may take place.

FIGURE 3 is a schematic cross-sectional diagram illustrating another embodiment of the surface-mounted substrate structure having an insulating protective coating 44 and as mounted on circuit board 36. Insulating protective coating 44 is preferably applied to the surface-mounted substrate structure when the device is in wafer form. The description of FIGURE 3 is similar to FIGURE 2 except that insulating protective coating 44 is provided in place of cover 38 in FIGURE 2. Insulating protective coating 44 provides an insulating layer over device 18 and the connections that are provided through the surface-mounted substrate structure of substrate 10. Insulating protective coating 44 provides a low cost alternative to the application of cover 38 of FIGURE 2 and may be applied to a wide variety of device types including both MEMS and conventional ICs, especially those devices not requiring windows for optical inputs or evacuated cavities. After insulating protective coating 44 is applied, the wafer is tested and diced. The device may be mounted and contact metal 22 and contact metal 28 may be coupled to conductor line 32 and conductor line 34, respectively, as described above in connection with FIGURE 2.

Thus, it is apparent there has been provided, a surface-mounted substrate structure and method for forming the same that satisfy the advantages set forth above. The illustrative embodiments reduces packaging costs and overall fabrication costs for both MEMS and IC devices and also allow more MEMS and IC devices to be mounted on a printed circuit board. Although a preferred embodiment has been described in detail, it should be understood that various changes, substitutions, and alterations can be made herein without departing from the scope of the present invention. For example, although the structure has been illustrated and described using conventional semiconductor fabrication techniques, other techniques, whether currently known or not, could potentially be used to fabricate the surface-mounted substrate structure of the present invention. Also, some of the steps described and illustrated in the preferred embodiment as discrete or separate steps may be combined into one step without departing from the scope of the present invention. Other examples of changes, substitutions, and alterations are readily ascertainable by one skilled in the art and could be made without departing from the spirit and scope of the present invention.

## Claims

**1.** A surface-mounted substrate structure comprising:
a substrate material having an interconnect opening extending between an upper surface and a lower surface thereof;
a conductive layer positioned within the interconnect opening, the conductive layer also positioned substantially above the upper surface and below the lower surface of the substrate material in an area around at least a portion of the interconnect opening; and
a dielectric layer positioned substantially between the conductive layer and the substrate material.

**2.** The structure of Claim 1, wherein the conductive layer comprises a doped semiconductor layer.

**3.** The structure of Claim 2, wherein the doped semiconductor layer comprises doped polysilicon.

**4.** The structure of any of Claims 1 to 3, wherein the substrate material comprises a plurality of interconnect openings.

**5.** The structure of any of Claims 1 to 4, wherein the substrate material comprises a silicon bulk substrate.

**6.** The structure of Claim 5, wherein the silicon bulk substrate comprises single-crystalline silicon.

**7.** The structure of any of Claims 1 to 6, further comprising a microelectronic mechanical system having a bonding pad, the bonding pad positioned adjacent to the interconnect opening on the upper surface of the substrate material.

**8.** The structure of any of Claims 1 to 7, further comprising an integrated circuit die having bonding pads, the bonding pads positioned adjacent to the interconnect opening on the upper surface of the substrate material.

**9.** The structure of Claim 7 or Claim 8, further comprising an interconnect conductor positioned to provide an electrical coupling between the bonding pad and the conductive layer.

**10.** The structure of any of Claims 1 to 9, further comprising a contact metal positioned adjacent to an exposed side of a portion of the conductive layer positioned within the interconnect opening and below the lower surface of the substrate material.

**11.** The structure of Claim 10, wherein the contact metal is arranged for mounting to a conductor of a circuit board.

**12.** The structure of Claim 10, wherein the contact metal is arranged for mounting to a conductor of a circuit board through a mounting material.

**13.** The structure of Claim 10, wherein the contact metal is arranged for mounting to a conductor of a packaging device.

**14.** The structure of any of Claims 1 to 13, wherein the dielectric layer comprises an oxide layer.

**15.** A packaged device comprising:
a substrate material having a plurality of interconnect openings extending between an upper surface and a lower surface thereof;
a conductive layer positioned within the interconnect openings, the conductive layer positioned substantially above the upper surface and below the lower surface of the substrate material in an area around at least a portion of each of the interconnect openings;
a dielectric layer positioned substantially between the conductive layer and the substrate material;
a microelectronic device having a plurality of bonding pads, each of the plurality of bonding pads positioned adjacent to a corresponding interconnect opening and conductive layer on the upper surface of the substrate material;
a plurality of interconnect conductors, each interconnect conductor positioned to provide an electrical coupling between each bonding pad and a corresponding conductive layer; and
a cover for encapsulating the microelectronic device.

**17.** The packaged device of Claim 16, wherein the dielectric layer comprises an oxide layer.

**18.** The packaged device of Claim 16 or Claim 17, wherein the cover comprises an insulating protective coating.

**19.** The packaged device of any of Claims 16 to 18, wherein the microelectronic device comprises a microelectronic mechanical system.

**20.** A method for fabricating a surface-mounted substrate structure comprising the steps of:
forming an interconnect opening from an upper surface to a lower surface of a substrate material;
forming a dielectric layer over an outer surface of the interconnect opening and the upper surface and the lower surface of the substrate material in an area around at least a portion of the interconnect opening; and
forming a conductive layer over the dielectric layer.

**21.** The method of Claim 20, wherein the step of forming a conductive layer comprises forming a doped semiconductor layer.

**22.** The method of Claim 20 or Claim 21, further comprising the step of:
forming a microelectronic mechanical system on the upper surface of the substrate material.

**23.** The method of any of Claims 20 to 22, further comprising the step of:
forming an integrated circuit using the substrate material.
